## Europäisches Patentamt
## European Patent Office
## Office européen des brevets

(11) Publication number: **0 145 256**
**B1**

(12) # EUROPEAN PATENT SPECIFICATION

(45) Date of publication of patent specification: **18.05.88**

(51) Int. Cl.⁴: **H 01 L 23/04, H 01 L 27/06**

(21) Application number: **84307640.7**

(22) Date of filing: **06.11.84**

(54) Darlington transistor pair units.

(30) Priority: **10.11.83 JP 173957/83 u**

(43) Date of publication of application:
**19.06.85 Bulletin 85/25**

(45) Publication of the grant of the patent:
**18.05.88 Bulletin 88/20**

(84) Designated Contracting States:
**DE FR GB**

(56) References cited:
**DE-B-2 353 333**
**GB-A-1 450 626**

(73) Proprietor: **FUJI ELECTRIC CO., LTD.**
**1-1, Tanabeshinden, Kawasaki-ku**
**Kawasaki-shi Kanagawa 210 (JP)**

(72) Inventor: **Shigekane, Hisao**
**B406, 180-10 Yokota**
**Matsumoto-shi Nagano-ken 390 (JP)**

(74) Representative: **Gordon, Martin et al**
**G.F. Redfern & Company Marlborough Lodge 14**
**Farncombe Road**
**Worthing West Sussex, BN11 2BT (GB)**

Courier Press, Leamington Spa, England.

EP 0 145 256 B1

## Description

This invention relates to Darlington transistor pair units and in particular to their external connecting terminal arrangements.

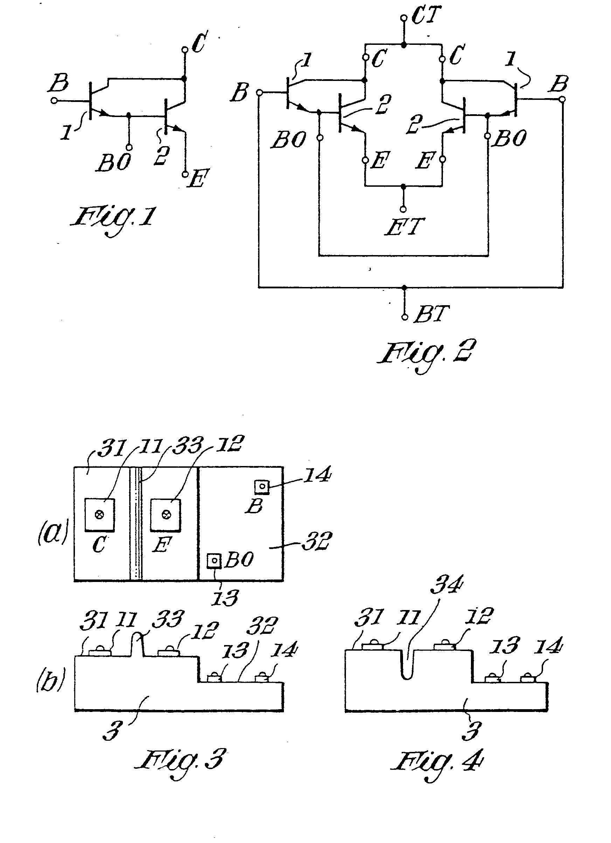

Reference will now be made to Figs. 1 to 3(b) of the accompanying drawings in which are shown various known Darlington transistor arrangements.

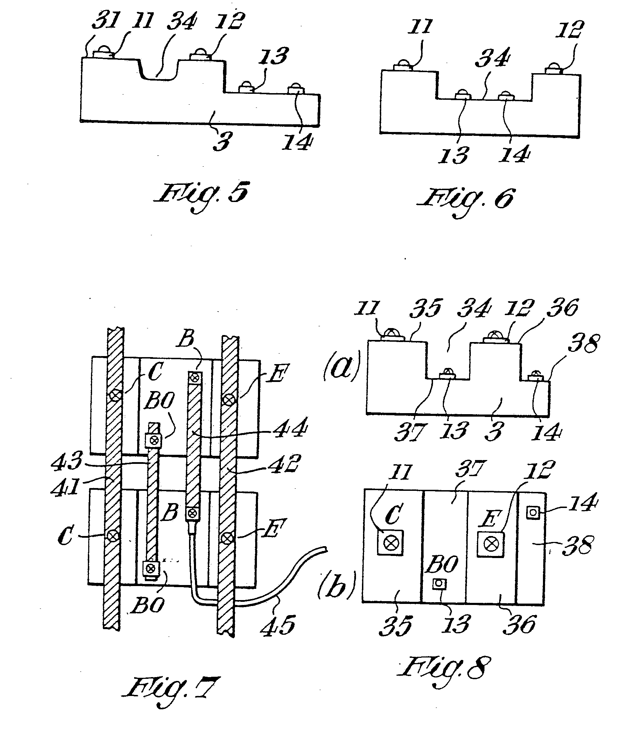

When using parallel-connected Darlington transistor pairs each comprising two transistors 1 and 2 (first-stage and second-stage respectively) connected as shown in Fig. 1, connections are made between the collector terminals C, between the base terminals B and between the emitter terminals E of the respective Darlington pairs to form a common collector terminal CT, a common base terminal BT and a common emitter terminal ET. A connection is also made between the intermediate emitter terminals BO of the first-stage transistors 1 of the two pairs as shown in Fig. 2 in order to minimise imbalance in the collector current of the respective transistors.

Where these four terminals are arranged on the upper surface of a Darlington transistor pair resin enclosure (e.g. encapsulation) whose base is joined to a heat sink body, an arrangement shown in Fig. 3 is obtained. Specifically, in order to provide an adequate insulation (creepage) distance between the arrangement of the collector terminal 11 and the emitter terminal 12, which are high current terminals and the arrangement of the intermediate emitter terminal 13 and the base terminal 14, which are low current terminals, the two arrangements are disposed on the respective upper surface portions 31 and 32 of the resin enclosure 3, said surface portions being separated by means of a step.

Further, in order to increase the insulation distance between the collector terminal 11 and the emitter terminal 12, a rib 33 is provided. However, this results in the disadvantage that the rib 33 causes problems where a printed board is to be directly mounted on to the collector terminal 11 and the emitter terminal 12 on the uppermost surface portion 31.

According to this invention there is provided a Darlington transistor pair unit comprising a Darlington transistor pair enclosed in a solid resin enclosure and having external connection terminals mounted on a stepped surface of the enclosure, said stepped surface being shaped to provide two relatively raised surface portions alternating with two relatively lower surface portions, first and second external connection terminals for the collector and emitter of the second-stage transistor being mounted respectively on said relatively raised surface portions, a third external connection terminal for the emitter of the first-stage transistor being mounted on the relatively lower surface portion between said raised surface portions and a fourth external connection terminal for the base of the first-stage transistor being mounted on the other lower surface portion which is at an outer side of said stepped surface.

Conveniently it may be arranged that said third terminal is positioned to one side of a notional line through the first and second terminals by a distance sufficient to ensure a desired predetermined insulation distance between the first and second terminals.

It may also be arranged that said fourth terminal is positioned to the other side of said notional line.

Two such units may advantageously be combined in a parallel-connected assembly, the stepped surfaces of the two units being arranged so that their respective corresponding surface portions are aligned, interconnections being provided between the corresponding terminals of the two units in the form of mutually parallel elongate conductive elements extending in the direction of said alignment.

An embodiment of this invention will now be described, by way of example, with reference to the accompanying drawings in which:—

Fig. 1 is a circuit diagram of a known Darlington transistor pair;

Fig. 2 is a circuit diagram of a known parallel-connected arrangement of two Darlington pairs shown in Fig. 1;

Figs. 3(a) and 3(b) are views of external surfaces of a known form of resin-enclosed Darlington pair unit;

Figs. 4 to 6 are views of external surfaces of respective various forms of Darlington pair units proposed and discarded by the inventor as unsatisfactory;

Fig. 7 is a plan view of the parallel-connected circuit arrangement shown in Fig. 2 in the form of a combination of two of the Darlington pair units shown in Fig. 6; and

Figs. 8(a) and 8(b) are side and plan views of a Darlington pair unit embodying this invention.

In order to overcome the disadvantages of the known devices shown in Figs. 1 to 3(b), the inventor proposed the provision of a groove 34 instead of the rib 33 on the upper surface portion 31, between the collector terminal 11 and the emitter terminal 12 as shown in Fig. 4. However, since a sufficient insulation distance can only be obtained by increasing the width of the groove 34 as shown in Fig. 5, this results in the disadvantage that the external size configuration of the container is increased.

In order to solve this problem, the inventor also proposed to arrange the B0 terminal 13 and the B terminal 14 on the bottom surface of the groove 34 as shown in Fig. 6.

In this structure however, where corresponding terminals fulfilling the same electrical requirements of two Darlington transistor pair units are interconnected by using bus bars 41 to 44 as shown in Fig. 7 and the C terminal and the E terminal are connected with a load or a power source via the bus bars 41, 42 in order to obtain the circuit arrangement shown in Fig. 2, the lead 45 connecting a base driving circuit with the base terminal must physically cross over either the bus bar 41 or 42 through which flows a high current from the power terminal. The base lead 45, in which only a low current flows, tends to be subject to interference due to electromagnetic induction from the bus bar 41, 42 and this distorts the base current waveform. An attempt to avoid the problem of the cross-over by means of the wiring makes the wiring complicated.

Referring to Fig. 8, the stepped upper surface of a resin enclosure 3 for a Darlington transistor pair unit comprises upper surface portions 35, 36 and lower surface portions 37, 38. The lower surface portion 37 is positioned between the higher surface portions 35 and 36 and the lower surface portion 38 is positioned on the outer side of the higher surface portion 36. A collector terminal 11 and an emitter terminal 12 are disposed on the respective surface portions 35, 36 and intermediate emitter terminal 13 and base terminal 14 of the transistor pair are disposed on the surface portions 37, 38 respectively.

In a parallel-connected arrangement of a plurality of such pair units, since the BO terminals 13 on the aligned lower surface portions 37 have connections extending only between the Darlington transistor pair unit there is no problem of cross-over with respect to either of the bus bars for the power wiring connecting the C and E terminals 11 and 12 with the load or the power source.

Further, since the B terminal 14 is positioned to the outer side of the E terminal 12, there is no problem due to cross-over between the base connection lead and the power wiring. In addition, a sufficient insulation distance is obtained between the C terminal 11 and the E terminal 12 across the groove 34 enhanced by disposing the BO terminal 13 at a position spaced from the line interconnecting the terminals 11 and 12. As a result, the external size of the resin enclosure 3 need not be increased as compared with the arrangement shown in Fig. 4 having a narrow groove 34.

The B terminal may be disposed to the outer side of the C terminal instead of to the outer side of the E terminal.

Thus with the embodiment described above the connecting lead cross-over problems encountered with the prior art arrangements can be overcome and a Darlington transistor pair unit having an adequate insulation distance and being readily mounted on to the printed board can be obtained.

Thus the embodiment described above provides a Darlington transistor pair unit comprising a Darlington transistor pair enclosed in a solid resin enclosure (3) and having external connection terminals (11, 12, 13, 14) mounted on a stepped surface (35, 36, 37, 38) of the enclosure (3), said stepped surface (35, 36, 37, 38) being shaped to provide two relatively raised surface portions (35, 36) alternating with two relatively lower surface portions (37, 38), first and second external connection terminals (11, 12) for the collector and emitter of the second-stage transistor being mounted respectively on said relatively raised surface portions (35, 36) a third external connection terminal (13) for the emitter of the first-stage transistor being mounted on the relatively lower surface portion (27) between said raised surface portions (35, 36) and a fourth external connection terminal (14) for the base of the first-stage transistor being mounted on the other lower surface portion (38) which is at an outer side of said stepped surface.

**Claims**

1. A Darlington transistor pair unit comprising a Darlington transistor pair enclosed in a solid resin enclosure and having external connection terminals mounted on a stepped surface of the enclosure, said stepped surface being shaped to provide two relatively raised surface portions alternating with two relatively lower surface portions, first and second external connection terminals for the collector and emitter of the second-stage transistor being mounted respectively on said relatively raised surface portions, a third external connection terminal for the emitter of the first-stage transistor being mounted on the relatively lower surface portion between said raised surface portions and a fourth external connection terminal for the base of the first-stage transistor being mounted on the other lower surface portion which is at an outer side of said stepped surface.

2. A Darlington transistor pair unit according to claim 1 wherein said third terminal is positioned to one side of a notional line through the first and second terminals by a distance sufficient to ensure a desired predetermined insulation distance between the first and second terminals.

3. A Darlington transistor pair unit according to claim 2 wherein said fourth terminal is positioned to the other side of said notional line.

4. A parallel-connected assembly of two Darlington pair units according to any one of the preceding claims, the stepped surfaces of the two units being arranged so that their respective corresponding surface portions are aligned, interconnections being provided between the corresponding terminals of the two units in the form of mutually parallel elongate conductive elements extending in the direction of said alignment.

**Patentansprüche**

1. Darlington Transistorpaareinheit bestehend aus einem in einer Umhüllung aus festem Harz enthaltenem Darlington Transistorpaar, deren außenliegenden Anschlüsse auf einer abgestuften Oberfläche der Umhüllung angebracht sind, wobei die abgestufte Oberfläche zwei relativ höhere Oberflächenabschnitte abwechselnd mit zwei relativ tieferen Oberflächenabschnitten aufweist und erste und zweite außenliegende Anschlüsse für den Kollektor une Emitter des Transistors de zweiten Stufe (Ausgangstransistor) auf den jeweils erhobenen Oberflächenabschnitten und ein dritter außenliegender Anschluß für den Emitter des Transistors der ersten Stufe (Eingangstransistor) auf dem niedrigeren Oberflächenabschnitt zwischen den erhobenen Oberflächenabschnitten und ein vierter außenliegender Anschluß für die Basis des Eingangstransistors auf dem anderen niedrigeren Oberflächenabschnitt, das an einer Außenseite der abgestuften Oberfläche liegt, angeordnet sind.

2. Darlington Transistorpaareinheit nach Anspruch 1, bei der der dritte Anschluß auf einer Seite einer durch den ersten und zweiten Anschluß gedachten Linie mit einem ein vorgegebenen Isolierabstand garantierenden Abstand zwischen dem ersten und dem zweiten Anschluß angeordnet ist.

3. Darlington Transistorpaareinheit nach Anspruch 2, bei der der vierte Anschluß auf der anderen Seite der gedachten Linie angeordnet ist.

4. Parallelschaltung von zwei Darlingtonpaareinheiten nach einem der vorhergehenden Ansprüche, dadurch gekennzeichnet, daß die abgestuften Oberflächen der zwei Einheiten derart angeordnet sind, daß ihre jeweils korrespondierenden Oberflächenabschnitte zueinander ausgerichtet sind und daß Zwischenverbindungen zwischen entsprechenden Anschlüssen von zwei Einheiten in form von zueinander parallelen in der Ausrichrichtung verlängerten, leitenden Elementen vorgesehen sind.

**Revendications**

1. Ensemble à paire de transistors de Darlington comprenant une paire de transistors de Darlington enfermée dans un boîtier en résine plein et ayant des bornes extérieures de connexion montées sur une surface étagée du boîtier, ladite surface étagée étant profilée pour présenter deux parties de surface relativement surélevées alternant avec deux parties de surface relativement plus basses, de première et seconde bornes extérieures de connexion pour le collecteur et l'émetteur du transistor du second étage étant respectivement montées sur lesdites parties de surface relativement surélevées, une troisième borne extérieure de connexion pour l'émetteur du transistor du premier étage étant montée sur la surface relativement plus basse entre lesdites parties de surface relativement surélevées et une quatrième borne extérieure de connexion pour la base du transistor du premier étage étant montée sur l'autre surface basse située sur un côté extérieur de ladite surface étagée.

2. Ensemble à paire de transistors de Darlington selon la revendication 1, dans lequel ladite troisième borne est située d'un côté d'une ligne imaginaire passant par les première et seconde bornes, à une distance suffisante pour assurer une distance d'isolement prédéterminée voulue entre les première et seconde bornes.

3. Ensemble à paire de transistors de Darlington selon la revendication 2, dans lequel ladite quatrième borne est située de l'autre côté de ladite ligne imaginaire.

4. Montage en parallèle de deux ensembles à paires de Darlington selon l'une quelconque des revendications précédentes, les surfaces étagées des deux ensembles étant disposées de façon que leurs parties de surfaces respectives correspondantes soient alignées, des interconnexions étant réalisées entre les bornes correspondantes des deux ensembles sous la forme d'éléments conducteurs allongés mutuellement parallèles s'étendant dans le sens dudit alignement.

Fig.1

Fig. 2

Fig.3

Fig. 4

1

**Fig. 5**

**Fig. 6**

**Fig. 7**

(a)

(b)

**Fig. 8**